# EUROPÄISCHE PATENTANMELDUNG

(11) **EP 2 375 232 A1**
(43) Veröffentlichungstag der Anmeldung: **12.10.2011**
(21) Anmeldenummer: 11153960.7
(22) Anmeldetag: 10.02.2011
(51) Int. Cl.: G01L 9/00, G01L 19/14, B81B 7/00

(54) **Drucksensoranordnung**

(30) Priorität: 08.04.2010 DE 102010003724
(71) Anmelder: Robert Bosch GmbH, 70442 Stuttgart (DE)
(72) Erfinder: Jahrsdoerfer, Bernd, 37293, Herleshausen (DE); Vollert, Jens, 99974, Muehlhausen (DE); Stark, Andreas, 98724, Lauscha (DE)

(57) **Zusammenfassung**

Es wird ein Aufbau für eine Drucksensoranordnung vorgeschlagen, der besonders einfach und kostengünstig ist, der für den Einsatz in aggressiven Messumgebungen ausgelegt ist und der sowohl eine Konfigurierung für Absolutdrucksensorelemente als auch für Relativdrucksensorelemente vorsieht.
Eine derartige Drucksensoranordnung umfasst mindestens ein mikromechanisches Drucksensorelement (1) mit einem Sensorbereich (11), in dem zumindest eine Sensormembran und Mittel zur Signalerfassung ausgebildet sind, und mit mindestens einem Anschlussbereich (12) zum Kontaktieren des Drucksensorelements (1), einen Träger (2) mit mindestens einer Druckanschlussöffnung (3), Mittel zum Schutz des Sensorbereichs und einen Schaltungsträger (7) mit Mitteln zur Signalverarbeitung.
Erfindungsgemäß ist der Träger (2) aus Kunststoff gefertigt. Das Drucksensorelement (1) ist direkt auf den Kunststoffträger (2) montiert, so dass die Sensormembran zumindest einseitig über die Druckanschlussöffnung (3) mit einem Messdruck beaufschlagbar ist. Außerdem ist eine Sensorkappe (5) zum Schutz des Sensorbereichs (11) mediendicht auf den Kunststoffträger (2) und das Drucksensorelement (1) montiert, so dass zumindest der Anschlussbereich (12) unter der Sensorkappe (5) hervorragt. Der Schaltungsträger (7) ist ebenfalls auf dem Kunststoffträger (2) montiert und mit dem Anschlussbereich (12) des Drucksensorelements (1) elektrisch verbunden.

## Beschreibung

### Stand der Technik

Die Erfindung betrifft eine Drucksensoranordnung, die sich insbesondere für den Einsatz im Niederdruckbereich eignet. Diese Drucksensoranordnung umfasst ein mikromechanisches Drucksensorelement mit einem Sensorbereich, in dem zumindest eine Sensormembran und Mittel zur Signalerfassung ausgebildet sind, und mit mindestens einem Anschlussbereich zum Kontaktieren des Drucksensorelements. Des Weiteren umfasst die Drucksensoranordnung einen Träger mit mindestens einer Druckanschlussöffnung, Mittel zum Schutz des Sensorbereichs und einen Schaltungsträger mit Mitteln zur Signalverarbeitung.

Eine derartige Drucksensoranordnung ist beispielsweise aus der deutschen Offenlegungsschrift DE 10 2005 056 760 A1 bekannt. Hier wird eine Drucksensoranordnung mit einem Si-Drucksensorchip beschrieben, der mit seiner Rückseite anodisch auf ein natriumhaltiges Glas (Pyrexglas) gebondet ist und über diesen Glassockel auf einen Keramikträger geklebt ist. Der Glassockel dient zur Stressentkopplung der montagebedingten Spannungen. Die Druckbeaufschlagung erfolgt hier über einen Druckkanal, der sich durch den Keramikträger, den Glassockel und den Sensorchip bis in eine Kaverne unter der Sensormembran in der Chipoberfläche erstreckt. Die Sensormembran ist mit Piezowiderständen als Mittel zur Signalerfassung ausgestattet. Im Peripheriebereich der Sensormembran sind weitere Schaltungselemente angeordnet, die über Bonddrähte mit Anschlüssen auf dem Keramikträger verbunden sind. Zum Schutz gegen Umwelteinflüsse wurde der Sensorchip in einem Ringgehäuse angeordnet, das auf dem Keramikträger montiert ist und auch den Anschlussbereich mit den Bonddrähten umgibt. Das Ringgehäuse ist mit einem Passivierungsgel befüllt, so dass der Sensorchip mit den Bonddrähten vollständig in das Passivierungsgel eingebettet ist und insbesondere die Schaltungselemente auf der Chipoberfläche vollständig bedeckt sind.

Der voranstehend beschriebene Aufbau einer Drucksensoranordnung ist relativ aufwendig in der Herstellung.

So wird der Sensorchip hier auf einem Träger montiert, der auch als Schaltungsträger fungieren soll. Als Trägermaterial wurde dementsprechend Keramik gewählt. Schon die Herstellung des Keramikträgers ist vergleichsweise aufwendig, da der Keramikträger sowohl mechanisch - zur Herstellung des Druckkanals - als auch schaltungstechnisch prozessiert werden muss. Außerdem erfordert das Keramik-Trägermaterial besondere Maßnahmen zur Stressentkopplung bei der Montage des Sensorchips, nämlich die Prozessierung eines Glaswafers unabhängig vom Sensorwafer, das anodische Bonden von Sensorwafer und Glaswafer und das Vereinzeln der mit einem Glassockel versehenen Sensorchips.

Zudem hat sich in der Praxis gezeigt, dass die üblicherweise verwendeten Passivierungsgels zumindest langfristig keinen hinreichenden Schutz gegen aggressive Medien bieten. Dadurch wird insbesondere auch die Funktionsfähigkeit von Schaltungselementen beeinträchtigt, was sich negativ auf die Verarbeitung und Auswertung der Messsignale auswirkt.

### Offenbarung der Erfindung

Mit der vorliegenden Erfindung wird ein Aufbau für eine Drucksensoranordnung der eingangs genannten Art vorgeschlagen, der besonders einfach und kostengünstig ist und insbesondere für den Einsatz in aggressiven Messumgebungen ausgelegt ist.

Dies wird erfindungsgemäß dadurch erreicht, dass ein Kunststoffträger als Träger für das Drucksensorelement verwendet wird und dass das Drucksensorelement direkt auf den Kunststoffträger montiert wird, so dass die Sensormembran zumindest einseitig über die Druckanschlussöffnung im Kunststoffträger mit einem Messdruck beaufschlagbar ist. Als Mittel zum Schutz des Sensorbereichs des Drucksensorelements wird eine Sensorkappe mediendicht auf den Kunststoffträger und das Drucksensorelement montiert, so dass zumindest der Anschlussbereich des Drucksensorelements unter der Sensorkappe hervorragt. Der Schaltungsträger wird ebenfalls auf dem Kunststoffträger montiert und mit dem Anschlussbereich des Drucksensorelements elektrisch verbunden.

Erfindungsgemäß ist erkannt worden, dass die Verwendung eines Kunststoffträgers in mehrerlei Hinsicht von Vorteil ist. So kann das Drucksensorelement bei geeigneter Wahl des Kunststoffmaterials direkt auf dem Kunststoffträger montiert werden, ohne dass die Qualität der Messergebnisse durch montagebedingte Spannungen im Aufbau zu sehr leidet. Dadurch wird die Montage - im Vergleich zu der aus der DE 10 2005 056 760 A1 bekannten Drucksensoranordnung - deutlich vereinfacht. Da der Kunststoffträger hier ausschließlich Gehäusefunktion hat und nicht als Schaltungsträger fungiert, kann der Kunststoffträger einfach mit einer oder alternativ auch mit zwei Druckanschlussöffnungen für Differenzdruckmessungen konfiguriert werden. Eine Anpassung an Drucksensorelemente und Schaltungsträger unterschiedlicher Größe und Form ist unkritisch. Auch bei der Montage der Sensorkappe, die in der Regel ebenfalls aus Kunststoff gefertigt ist, erweist sich der Kunststoffträger als vorteilhaft. So lässt sich bei Kombination geeigneter Kunststoffmaterialen mit einem vergleichsweise geringen Aufwand eine medien- und druckdichte Verbindung zwischen der Sensorkappe und dem Kunststoffträger herstellen. Die Sensorkappe überspannt den Sensorbereich des Drucksensorelements und schützt den außerhalb der Sensorkappe liegenden Elektronikbereich zuverlässig gegen Umwelteinflüsse.
Erfindungsgemäß werden Signalverarbeitungsfunktionen in einem eigenen Schaltungsträger implementiert, der unabhängig vom Drucksensorelement ebenfalls auf dem Kunststoffträger montiert wird. Dadurch kann die erfindungsgemäße Drucksensoranordnung wahlweise mit mehr oder weniger Schaltungsfunktionen ausgestattet werden, je nach dem, wo und für welchen Zweck die erfindungsgemäße Drucksensoranordnung eingesetzt werden soll.

In einer vorteilhaften Variante der erfindungsgemäßen Drucksensoranordnung wird im Kunststoffträger zusätzlich zur ersten Druckanschlussöffnung, über der das Drucksensorelement montier ist, noch eine zweite Druckanschlussöffnungen neben den Drucksensorelement ausgebildet. Diese zweite Druckanschlussöffnung mündet in den Raum unter der Sensorkappe, so dass der zweite Messdruck auf die Oberseite der Membran einwirkt. Bei dieser Variante bildet der Kunststoffträger zusammen mit der Sensorkappe einen zweiten Druckanschluss für das Sensorelement. Das Messmedium wird hier zwar auf die Oberseite des Drucksensorelements geführt, kommt aber nur mit den Schaltungselementen im Sensorbereich in Kontakt. Weder der Anschlussbereich des Drucksensorelements noch der Schaltungsträger mit der Signalverarbeitung ist einem Angriff des Messmediums ausgesetzt.

Im Hinblick auf die Kompaktheit und Robustheit der Drucksensoranordnung ist es von besonderem Vorteil, wenn im Kunststoffträger Vertiefungen für das Drucksensorelement und/oder den Schaltungsträger ausgebildet sind, die so dimensioniert sind, dass die Oberflächen dieser Bauelemente und die Oberfläche des Kunststoffträgers eine Ebene bilden. Die Bauelemente sind in diesem Fall sehr gut gegen Umwelteinflüsse geschützt.

Als Kunststoffe für den Kunststoffträger und die Sensorkappe eignen sich beispielsweise PPS, PA, PBT, PEEK oder LCP. Die Montage des Drucksensorelements, des Schaltungsträgers sowie der Sensorkappe auf dem Kunststoffträger erfolgt vorteilhafterweise durch Kleben. Diese Variante ist nicht nur besonders kostengünstig sondern trägt auch zur Stressentkopplung zwischen Drucksensorelement und Kunststoffträger bei.

An dieser Stelle sei noch angemerkt, dass sich die erfindungsgemäße Drucksensoranordnung aufgrund ihres einfachen Aufbaus sehr gut in unterschiedlichste anwendungsspezifisches Gehäuse einbauen lässt, wo sie mit weiteren Sensorelementen, wie z.B. einem Temperatursensor, einfach kombiniert werden kann.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die den unabhängigen Patentansprüchen nachgeordneten Patentansprüche verwiesen und andererseits auf die nachfolgende Beschreibung mehrerer Ausführungsbeispiele der Erfindung anhand der Zeichnungen.
- **Fig.1**: zeigt eine schematische Schnittdarstellung durch eine erste erfindungsgemäße Drucksensoranordnung 10 zur Absolutdruckmessung,
- **Fig. 2**: zeigt eine schematische Schnittdarstellung durch eine erfindungsgemäße Drucksensoranordnung 20 zur Differenzdruckmessung
- **Fig. 3**: zeigt eine schematische Schnittdarstellung durch ein Sensorgehäuse 30 mit einer erfindungsgemäßen Drucksensoranordnung und einem Temperatursensor und
- **Fig. 4**: zeigt eine schematische Schnittdarstellung durch eine zweite erfindungsgemäße Drucksensoranordnung 40 zur Absolutdruckmessung.

### Ausführungsformen der Erfindung

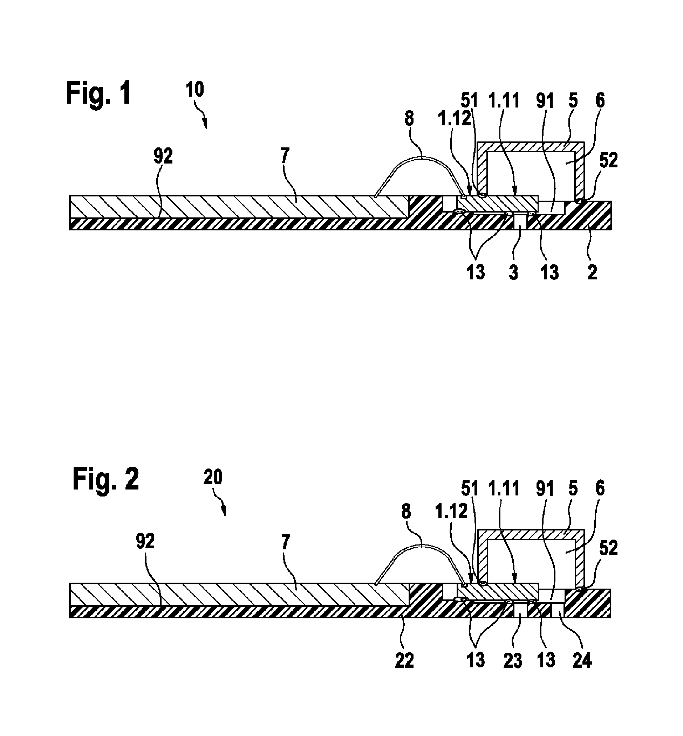

Die in **Fig. 1** dargestellte Sensoranordnung 10 dient der Absolutdruckmessung im Niederdruckbereich. Dazu ist sie mit einem für Absolutdruckmessungen ausgelegten Drucksensorelement in Form eines mikromechanischen Sensorchips 1 ausgestattet. In der Chipoberfläche ist eine Sensormembran ausgebildet, auf der Piezowiderstände zur Signalerfassung angeordnet sind, was hier allerdings nicht im Einzelnen dargestellt ist. Vielmehr ist hier lediglich der Chipbereich mit der Sensormembran als Sensorbereich 11 bezeichnet, im Unterschied zu einem Anschlussbereich 12, wo die äußeren elektrischen Kontakte des Sensorchips 1 angeordnet sind.

Erfindungsgemäß ist der Sensorchip 1 direkt auf einem flächigen Kunststoffträger 2 montiert, der mit einer Durchgangsöffnung als Druckanschlussöffnung 3 versehen ist. Der Sensorchip 1 ist so über der Druckanschlussöffnung 3 im Kunststoffträger 2 montiert, dass die Sensormembran rückseitig mit einem Messdruck beaufschlagbar ist.

Des Weiteren umfasst die Drucksensoranordnung 10 eine Sensorkappe 5, die so auf dem Kunststoffträger 2 und dem Sensorchip 1 montiert ist, dass sie einen Raum 6 über dem Sensorbereich 11 abschließt, aus dem aber der Anschlussbereich 12 des Sensorchips 1 herausragt. Diese Sensorkappe 5 ist mediendicht montiert und schützt den Sensorbereich 11 so vor Umwelteinflüssen. Die Sensorkappe ist bei dieser Variante nicht zwingend erforderlich, da die Klebung 13 eine Dichtklebung ist, die für die Messzeit ausreichende Dichtheit gewährleistet. Die Sensorkappe dient aber in jeden Fall als zusätzlicher Schutz des Sensors. Schließlich umfasst die Drucksensoranordnung 10 noch einen Schaltungsträger 7 mit Mitteln zur Signalverarbeitung, der neben dem Anschlussbereich 12 des Sensorchips 1 auf dem Kunststoffträger 2 montiert ist und über Bonddrähte 8 mit dem Sensorchip 1 elektrisch verbunden ist.

Im hier dargestellten Ausführungsbeispiel sind in der Oberseite des flächigen Kunststoffträgers 2 zwei Vertiefungen 91 und 92 zur Aufnahme des Sensorchips 1 und des Schaltungsträgers 7 ausgebildet. Diese Vertiefungen 91 und 92 sind jeweils so dimensioniert, dass die Oberfläche des Sensorchips 1 bzw. des Schaltungsträgers 7 in die Oberfläche des Kunststoffträgers 2 eingebettet sind und eine Ebene mit der Trägeroberfläche bilden.

Sowohl der Sensorchip 1 als auch der Schaltungsträger 7 und die Sensorkappe 5 sind auf die Trägeroberfläche geklebt. Die so realisierte mechanische Verbindung muss im Falle des Sensorchips 1 und der Sensorkappe 5 zumindest mediendicht sein. Dies wurde im Fall des Sensorchips 1 durch spezielle Dichtklebungen 13 und im Fall der Sensorkappe 5 durch eine sogenannte Schwertklebung 51 erreicht.

Die in **Fig. 2** dargestellte Sensoranordnung 20 ist genauso aufgebaut wie die Sensoranordnung 10, dient aber im Unterschied zur Sensoranordnung 10 nicht der Absolutdruckmessung sondern ist mit einem Drucksensorelement 21 für Differenzdruckmessungen ausgestattet und entsprechend konzipiert. Dazu wurde der Kunststoffträger 22 modifiziert. Im Unterschied zum Kunststoffträger 2 der Sensoranordnung 10 weist der Kunststoffträger 22 zwei Druckanschlussöffnungen 23 und 24 auf. Der Sensorchip 21 ist über der ersten Druckanschlussöffnung 23 montiert, so dass die Sensormembran rückseitig mit einem ersten Messdruck beaufschlagbar ist. Die zweite Druckanschlussöffnung 24 mündet neben dem Sensorchip 21 in den Raum 6 unter der Sensorkappe 5, so dass der zweite Messdruck über die zweite Druckanschlussöffnung 24 auf die Vorderseite der Sensormembran geleitet wird. Da die übrigen Komponenten der Sensoranordnung 20 mit denen der Sensoranordnung 10 übereinstimmen, sind sie mit denselben Bezugszeichen versehen und es wird an dieser Stelle auf die entsprechende Beschreibung zur Fig. 1 verwiesen.

Bei beiden in Verbindung mit den Figuren 1 und 2 beschriebenen Niederdruck-Sensoranordnungen ist der Sensorchip 1 bzw. 21 mit einem Schaltungsträger 7 elektrische verbunden und bietet mehrere externe Kontaktmöglichkeiten im Anschlussbereich 12. Die beiden voranstehend beschriebenen Ausführungsbeispiele veranschaulichen, dass sich im Rahmen des erfindungsgemäßen Aufbaukonzepts durch geringfügige Modifikation des Kunststoffträgers 2 bzw. 22 sowohl Drucksensoranordnungen zur Absolutdruckmessung als auch zur Relativdruckmessung realisieren lassen. Diese Drucksensoranordnungen weisen eine sehr hohe Medienbeständigkeit auf, so dass ihre Funktionsfähigkeit auch über Lebensdauer gewährleistet werden kann.

Die Herstellungskosten für eine erfindungsgemäße Drucksensoranordnung, wie sie voranstehend beschrieben worden ist, sind relativ gering. Dies ist in erster Linie auf den einfachen Aufbau und die Verwendung eines Kunststoffträgers zurückzuführen. Ein wesentlicher Kostenvorteil wird dadurch erzielt, dass der Drucksensorchip 1 bzw. 21 direkt auf den Kunststoffträger 2 bzw. 22 geklebt wird und auch die Sensorkappe 5 mediendicht aufgeklebt wird. Ein weiterer Kostenvorteil kann durch die Verwendung eines vergleichsweise günstigen Schaltungsträgers erzielt werden, wie z.B. einer Leiterplatte anstelle eines Keramikhybrids oder eines PCPs. Von besonderem Vorteil im Hinblick auf die Herstellungskosten ist, dass die erfindungsgemäße Drucksensoranordnung als "Großnutzen" aufgebaut und abgeglichen werden kann.

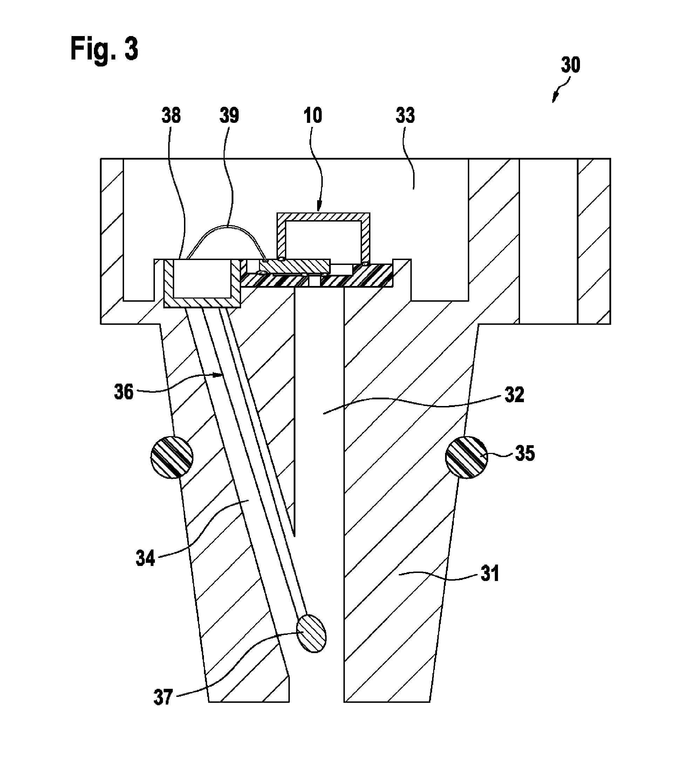

**Fig. 3** veranschaulicht die Einsatzmöglichkeiten einer erfindungsgemäßen Drucksensoranordnung 10 in Kombination mit weiteren Sensoren in einem gemeinsamen Gehäuse 30. Bei dem Gehäuse 30 handelt es sich um ein Kunststoffgehäuse mit einem konischen Anschlussstutzen 31, über den das Gehäuse 30 an einen hier nicht dargestellten Messraum angekoppelt wird. Mit Hilfe eines Dichtrings 35 wird die Verbindung zwischen Anschlussstutzen 31 und Messraum abgedichtet. Im Anschlussstutzen 31 ist ein Druckkanal 32 ausgebildet, der in den Gehäuseraum 33 mündet. Die Drucksensoranordnung 10 wurde so über den Mündungsbereich des Druckkanals 32 in das Gehäuse 30 eingeklebt, dass der Druckkanal 32 und die Druckanschlussöffnung 3 im Kunststoffträger 2 fluchtend zueinander angeordnet sind. Neben der Drucksensoranordnung 10 ist noch ein Temperatursensor 36 im Gehäuse 30 angeordnet. Dieser Temperatursensor 36 besteht aus einem NTC-Widerstandselement 37, das durch einen weiteren Kanal 34 im Anschlussstutzen 31 in den unteren Bereich des Druckkanals 32 geführt ist. Das NTC-Widerstandselement 37 ist über ein Kontaktplättchen 38 in das Gehäuse 30 eingeklebt und mit Hilfe von Bonddrähten 39 mit dem Schaltungsträger 7 der Drucksensoranordnung 10 verbunden. Die äußere elektrische Kontaktierung erfolgt über das hier nicht dargestellte Stanzgitter des Gehäuses 30.

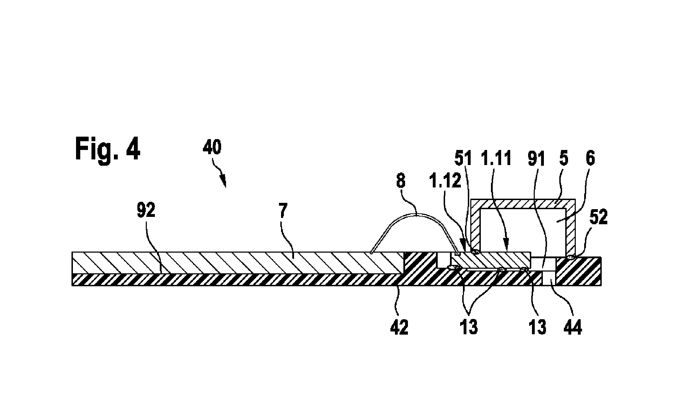

Die in **Fig. 4** dargestellte Sensoranordnung 40 dient der Absolutdruckmessung im Niederdruckbereich. Dazu ist sie mit einem Absolutdrucksensor mit Druckbeaufschlagung auf der Sensorseite in Form eines mikromechanischen Sensorchips 1 ausgestattet. In der Chipoberfläche ist eine Sensormembran ausgebildet, auf der Piezowiderstände zur Signalerfassung angeordnet sind, was hier allerdings nicht im Einzelnen dargestellt ist. Vielmehr ist hier lediglich der Chipbereich mit der Sensormembran als Sensorbereich 11 bezeichnet, im Unterschied zu einem Anschlussbereich 12, wo die äußeren elektrischen Kontakte des Sensorchips 1 angeordnet sind.

Erfindungsgemäß ist der Sensorchip 1 direkt auf einem flächigen Kunststoffträger 42 montiert, und zwar in einer für den Sensorchip 1 vorgesehenen Vertiefung 91. Im Bereich dieser Vertiefung 91 befindet sich eine Durchgangsöffnung 44 im Kunststoffträger 42, die als Druckanschlussöffnung dient. Der Sensorchip 1 ist hier neben der Druckanschlussöffnung 44 montiert.
Des Weiteren umfasst die Drucksensoranordnung 40 eine Sensorkappe 5, die so auf dem Kunststoffträger 42 und dem Sensorchip 1 montiert ist, dass sie einen Raum 6 über der Druckanschlussöffnung und dem Sensorbereich 11 abschließt, aus dem aber der Anschlussbereich 12 des Sensorchips 1 herausragt. Diese Sensorkappe 5 ist so montiert, dass die Sensormembran auf der Chipoberseite über die Druckanschlussöffnung mit einem Messdruck beaufschlagbar ist. Zudem schützt die Sensorkappe 5 den Sensorbereich 11 vor Umwelteinflüssen Schließlich umfasst die Drucksensoranordnung 40 noch einen Schaltungsträger 7 mit Mitteln zur Signalverarbeitung, der neben dem Anschlussbereich 12 des Sensorchips 1 in einer entsprechenden Vertiefung 92 des Kunststoffträgers 42 montiert ist und über Bonddrähte 8 mit dem Sensorchip 1 elektrisch verbunden ist. Die Vertiefungen 91 und 92 sind hier jeweils so dimensioniert, dass die Oberfläche des Sensorchips 1 bzw. des Schaltungsträgers 7 in die Oberfläche des Kunststoffträgers 42 eingebettet sind und eine Ebene mit der Trägeroberfläche bilden.

Sowohl der Sensorchip 1 als auch der Schaltungsträger 7 und die Sensorkappe 5 sind auf die Trägeroberfläche geklebt. Die so realisierte mechanische Verbindung muss im Falle des Sensorchips 1 und der Sensorkappe 5 druckdicht sein. Dies wurde im Fall des Sensorchips 1 durch spezielle Dichtklebungen 13 und im Fall der Sensorkappe 5 durch eine sogenannte Schwertklebung 51 erreicht.

## Patentansprüche

1. Drucksensoranordnung, mindestens umfassend
- ein mikromechanisches Drucksensorelement (1) mit einem Sensorbereich (11), in dem zumindest eine Sensormembran und Mittel zur Signalerfassung ausgebildet sind, und mit mindestens einem Anschlussbereich (12) zum Kontaktieren des Drucksensorelements (1),
- einen Träger (2) mit mindestens einer Druckanschlussöffnung (3),
- Mittel zum Schutz des Sensorbereichs und
- einen Schaltungsträger (7) mit Mitteln zur Signalverarbeitung;
**dadurch gekennzeichnet, dass** der Träger (2) aus Kunststoff gefertigt ist, dass das Drucksensorelement (1) direkt auf den Kunststoffträger (2) montiert ist, so dass die Sensormembran zumindest einseitig über die Druckanschlussöffnung (3) mit einem Messdruck beaufschlagbar ist, dass eine Sensorkappe (5) zum Schutz des Sensorbereichs (11) mediendicht auf den Kunststoffträger (2) und das Drucksensorelement (1) montiert ist, so dass zumindest der Anschlussbereich (12) unter der Sensorkappe (5) hervorragt, und dass der Schaltungsträger (7) ebenfalls auf dem Kunststoffträger (2) montiert ist und mit dem Anschlussbereich (12) des Drucksensorelements (1) elektrisch verbunden ist.

2. Drucksensoranordnung (20) nach Anspruch 1, **dadurch gekennzeichnet, dass** im Kunststoffträger (22) zwei Druckanschlussöffnungen (23, 24) ausgebildet sind, dass das Drucksensorelement (1) über der ersten Druckanschlussöffnung (23) montiert ist, so dass ein erster Messdruck an die Unterseite der Sensormembran geführt wird, und dass die zweite Druckanschlussöffnung (24) neben dem Drucksensorelement (1) unter die Sensorkappe (5) geführt ist, so dass ein zweiter Messdruck auf die Oberseite der Membran einwirkt.

3. Drucksensoranordnung nach einem der Ansprüche 1 oder 2, **dadurch gekennzeichnet, dass** im Kunststoffträger (2) eine erste Vertiefung (91) für das Drucksensorelement (1) ausgebildet ist, die so dimensioniert ist, dass die Oberfläche des montierten Drucksensorelements (1) und die Oberfläche des Kunststoffträgers (2) eine Ebene bilden.

4. Drucksensoranordnung nach einem der Ansprüche 1 bis 3, **dadurch gekennzeichnet, dass** im Kunststoffträger (2) eine zweite Vertiefung (92) für den Schaltungsträger (7) ausgebildet ist, die so dimensioniert ist, dass die Oberfläche des montierten Schaltungsträgers (7) und die Oberfläche des Kunststoffträgers (2) eine Ebene bilden.

5. Drucksensoranordnung nach einem der Ansprüche 1 bis 4, **dadurch gekennzeichnet, dass** das Drucksensorelement (1), der Schaltungsträger (7) und/oder die Sensorkappe (5) auf den Kunststoffträger (2) geklebt sind.

6. Drucksensorelement nach einem der Ansprüche 1 bis 5, **dadurch gekennzeichnet, dass** der Kunststoffträger und/oder die Sensorkappe aus PPS, PA, PBT oder LCP gefertigt sind.
